# EUROPEAN PATENT SPECIFICATION

(11) **EP 2 614 123 B1**
(45) Date of publication and mention of the grant of the patent: **28.06.2017**
(21) Application number: 11823142.2
(22) Date of filing: 06.09.2011
(51) Int. Cl.: C09G 1/02, C09G 1/04, C09G 1/18, C09K 3/14, C03C 19/00, H01L 21/3105

(54) **AQUEOUS POLISHING COMPOSITION AND PROCESS FOR CHEMICALLY MECHANICALLY POLISHING SUBSTRATE MATERIALS FOR ELECTRICAL, MECHANICAL AND OPTICAL DEVICES**
WÄSSRIGE POLIERZUSAMMENSETZUNG UND VERFAHREN ZUM CHEMISCH-MECHANISCH POLIEREN VON SUBSTRATMATERIALIEN FÜR ELEKTRISCHE, MECHANISCHE UND OPTISCHE VORRICHTUNGEN
COMPOSITION AQUEUSE DE POLISSAGE ET PROCÉDÉ DE POLISSAGE CHIMICO-MÉCANIQUE DE MATÉRIAUX DE SUBSTRAT POUR DISPOSITIFS OPTIQUES, MÉCANIQUES ET ÉLECTRIQUES

(30) Priority: 08.09.2010 US 380723 P
(43) Date of publication of application: 17.07.2013
(73) Proprietor: BASF SE, 67056 Ludwigshafen am Rhein (DE)
(72) Inventor: LI, Yuzhuo, 69123 Heidelberg (DE); CHU, Jea-Ju, Taipei City 111 (TW); VENKATARAMAN, Shyam, Sundar, Taoyuan County 320 (TW); USMAN IBRAHIM, Sheik, Ansar, Potsdam NY 13676 (US); PINDER, Harvey, Wayne, Chicago IL 60659 (US)
(74) Representative: BASF IP Association
(86) International application number: PCT/IB2011/053896
(87) International publication number: WO 2012/032469

(56) References cited:
- EP-A1- 1 369 906
- WO-A1-2009/098924
- WO-A1-2009/107986
- CN-A- 101 065 458
- CN-A- 101 679 810
- US-A- 5 759 917
- US-A1- 2010 151 684
- US-B1- 6 616 514

## Description

The present invention is directed to a novel aqueous polishing composition which is particularly suitable for polishing substrate materials for electrical, mechanical and optical devices.

Moreover, the present invention is directed to a novel process for polishing substrate materials for manufacturing electrical, mechanical and optical devices.

Last but not least, the present invention is directed to the novel use of the novel aqueous polishing composition for manufacturing electrical, mechanical and optical devices

### Cited Documents

The documents cited in the present application are incorporated by reference in their entirety.

### Background of the Invention

Chemical mechanical planarization or polishing (CMP) is the primary process to achieve local and global planarity of integrated circuits (ICs) devices. The technique typically applies CMP compositions or slurries containing abrasives and other additives as an active chemistry between a rotating substrate surface and a polishing pad under an applied load. Thus, the CMP process couples a physical process such as abrasion with a chemical process such as oxidation or chelation. It is not desirable for the removal or polishing of substrate materials to be comprised of purely physical or purely chemical action, but rather the synergistic combination of both in order to achieve a fast uniform removal.

This way, the substrate material is removed until the desired planarity is achieved or a barrier sublayer or stopping layer is exposed. Ultimately, a planar, defect-free surface is obtained which enables proper multilayer IC device fabrication by subsequent photolithography, patterning, etching and thin-film processing.

Shallow trench isolation (STI) is a specific CMP application which generally requires the selective removal of silicon dioxide to silicon nitride on a patterned wafer substrate. In this case, etched trenches are overfilled with a dielectric material, e.g., silicon dioxide, which is polished using the silicon nitride barrier film as the stopping layer. The CMP process ends with clearing the silicon dioxide from the barrier film while minimizing the removal of exposed silicon nitride and trench silicon oxide.

This requires CMP slurries capable of achieving a high relative ratio of silicon dioxide material removal rate MRR to silicon nitride removal rate MRR which ratio is also referred to in the art as oxide-to-nitride selectivity.

Ceria-based CMP slurries have received considerable attention in STI applications because of their ability to achieve a comparatively high oxide-to-nitride selectivity due to the high chemical affinity of ceria to silicon dioxide which is also referred to in the art as the chemical tooth action of ceria.

Nevertheless, the oxide-to-nitride selectivity of ceria-based CMP slurries must be improved by additives which "tailor" the selectivity.

Numerous attempts have been made to tailor the selectivity of ceria-based CMP slurries.

Thus, Jae-Don Lee et al. disclose in Journal of the Electrochemical Society, 149 (8), G477-G481, 2002, the effects of nonionic surfactants with different hydrophile-lipophile-balance (HLB) values such as polyethyleneoxides, ethyleneoxide-propyleneoxide copolymers and ethyleneoxide-propyleneoxide-ethyleneoxide triblock copolymers on oxide-to-polysilicon selectivity during CMP. However, fumed silica is used as the abrasive.

Jae-Dong Lee et al. disclose in Journal of the Electrochemical Society, 149 (8) G477-G481, 2002, Effects of Nonionic Surfactants on Oxide-To-Polysilicon Selectivity during Chemical Mechanical Polishing, the influence of surfactants such as polyethylene oxide (PEO) and ethyleneoxide-propyleneoxide-ethyleneoxide triblock copolymers on the selectivity. However, the oxide-to-nitride selectivity is not addressed.

The American patent US 5,738,800, US 6, 042, 741, US 6,132,637 and US 6,218,305 B disclose a ceria-based CMP slurry containing complexing agents such as malic acid, tartaric acid, gluconic acid, citric acid, ortho di- and polyhydroxybenzoic acids, phthalic acid, pyrocathechol, pyrogallol, gallic acid, tannic acid and their salts. Moreover, the ceria-based CMP slurry contains an anionic, cationic, amphoteric or nonionic surfactant The ceria-based CMP slurry is claimed to have a high oxide-to-nitride selectivity.

The American patents US 5,759,917, US 6,689,692 B1 and US 6,984,588 B2 disclose a ceria-based CMP slurry containing a carboxylic acid such as acetic acid, adipic acid, butyric acid, capric acid, caproic acid, caprylic acid, citric acid, glutaric acid, glycolic acid, formic acid, fumaric acid, lactic acid, lauric acid, malic acid, maleic acid, malonic acid, myristic acid, oxalic acid, palmitic acid, phthalic acid, propionic acid, pyruvic acid, stearic acid, succinic acid, tartaric acid, valeric acid, 2-(2-methoxyethoxy) acetic acid, 2-[2-(2-methoxyethoxy)ethoxy] acetic acid, poly(ethylene glycol)bis(carboxymethyl)ether and their derivatives and salts. In addition, the ceria-based CMP slurry contains water-soluble organic and inorganic salts such as nitrates, phosphates and sulfates. The ceria-based CMP slurry is claimed to polish a silicon oxide overfill in preference to a silicon nitride layer.

The American patent US 6,299,659 B1 discloses a ceria-based CMP slurry wherein the abrasive particles have been treated with a silane, titanate, circonate, aluminum and phosphate coupling agent in order to improve the oxide-to-nitride selectivity.

The American patent application US 2002/0034875 A1 and the American patent US 6,626,968 B2 disclose a ceria-based CMP slurry containing surfactants, pH adjusting agents such as potassium hydroxide, sulfuric acid, nitric acid, hydrochloric acid or phosphoric acid, and polymers containing a hydrophilic functional group and a hydrophobic functional group such as polyvinyl methyl ether (PVME), polyethylene glycol (PEG), polyoxyethylene 23 lauryl ether (POLE), polypropanoic acid (PPA), polyacrylic acid (PM), and polyether glycol bis ether (PEGBE). However, this ceria-based CMP slurry increases the oxide-to-polysilicon selectivity.

The American patent US 6,436,835 B1 discloses a ceria-based CMP slurry for the shallow trench isolation process comprising water-soluble organic compounds having carboxylic acid or carboxylate or sulfonic acid or sulfamic groups such as polyacrylic acid, polymethacrylic acid, naphthalene sulfonic acid-formalin condensate, malic acid, lactic acid, tartaric acid, gluconic acid, citric acid, succinic acid, adipic acid, fumaric acid, aspartic acid, glutamic acid, glycine 4-aminobutyric acid, 6-aminohexanoic acid, 12-aminolauric acid, arginine, glycylglycine, laurylbenzene sulfonic acid and their ammonium salts. The ceria-based CMP slurry can have a pH of equal to or less than 4 also a pH of higher than 4 is preferred. It is claimed to have a high oxide-to-nitride selectivity.

The American patents US 6,491,843 B1, US 6,544,892 B2 and US 6,627,107 B2 disclose a ceria-based CMP slurry containing alpha-amino acids such as lysine, alanine, and proline for improving the oxide-to-nitride selectivity.

The American patent US 6,616,514 B1 discloses a ceria-based CMP slurry containing organic polyols having at least 3 hydroxyl groups that are not dissociable in the aqueous medium; or a polymer formed from at least one monomer having at least 3 hydroxyl groups that are not dissociable in the aqueous medium such as mannitol, sorbitol, mannose, xylitol, sorbose, sucrose, and dextrin for improving the oxide-to-nitride selectivity.

The American patent application US 2006/0207188 A1 discloses a ceria-based CMP slurry containing the reaction product of a polymer such as polyacrylic acid or poly(alkyl methacrylate) and a monomer such as acrylamide, methacrylamide, ethylmethacrylamide, vinylpyridine, or vinylpyrrolidone. The reaction products are believed to increase also the oxide-to-nitride selectivity.

The American patent application US 2006/0216935 A1 discloses a ceria-based CMP slurry comprising protein, lysine and/or arginine and a pyrrolidone compounds such as polyvinylpyrrolidone (PVP), N-octyl-2-pyrrolidone, N-ethyl-2-pyrrolidone, N-hydroxyethyl-2-pyrrolidone, N-cyclohexyl-2-pyrrolidone, N-butyl-2-pyrrolidone, N-hexyl-2-pyrrolidone, N-decyl-2-pyrrolidone, N-octadecyl-2-pyrrolidone, and N-hexadecyl-2-pyrrolidone. The ceria-based CMP slurry can furthermore contain dispersing agents like polyacrylic acid, glycols and polyglycols. Specific examples use proline, polyvinylpyrrolidone or N-octyl-2-pyrrolidone, PPO/PEO blockcopolymers, and glutaraldehyde. The ceria-based CMP slurry is believed to not aggressively remove trench silicon dioxide thereby allowing for extended polishing beyond the endpoint without substantially increasing the minimum step height.

The American patent application US 2007/0077865 A1 discloses a ceria-based CMP slurry containing polyethyleneoxides/polypropyleneoxide copolymers preferably from the Pluronic™ family is sold by BASF. The ceria-based CMP slurry can furthermore contain amino alcohols such as 2-dimethylamino-2-methyl-1-propanol (DMAMP), 2-amino-2-ethyl-1-propanol (AMP), 2-(2-aminoethylamino)ethanol, 2-(isopropylamino)ethanol, 2-(methylamino)ethanol, 2-(diethylamino)ethanol, 2-(2-dimethylamino)ethoxy)ethanol, 1,1'-[[3-(dimethylamino)propyl]imino]-bis-2-propanol, 2-(2-butylamino)ethanol, 2-(tert-butylamino)ethanol, 2-(diisopropylamino)ethanol, and N-(3-aminopropyl)morpholine. The ceria-based CMP slurry may furthermore contain quaternary ammonium compounds like tetramethylammonium hydroxide, film forming agents such as alkyl amines, alkanolamines, hydroxyl amines, phosphate esters, sodium lauryl sulfate, fatty acids, polyacrylates, polymethacrylates, polyvinylphosphonates, polymalates, polystyrene sulfonate, polyvinyl sulfate, benzotriazole, triazole, and benzoimidazole, and complexing agents such as acetylacetone, acetates, glycolates, lactates, gluconates, gallic acid, oxalates, phthalates, citrates, succinates, tartates, malates, ethylenediaminetetraacetic acid, ethylene glycol, pyrocatechol, pyrogallol, tannic acid, phosphonium salts and phosphonic acids. The ceria-based CMP slurry is believed to provide good selectivity of silicon oxide and/or silicon nitride relative to polysilicon.

The American patent application US 2007/0175104 A1 discloses a ceria-based CMP slurry comprising a polysilicon polishing inhibitor which is selected from water-soluble polymers having a N-monosubstituted or N,N-di-substituted skeleton substituted by any members selected from the group consisting of acrylamide, methacrylamide and alpha-substituted derivatives thereof; polyethylene glycols; polyvinylpyrrolidones; alkyloxylated linear aliphatic alcohols and ethyleneoxide adducts of acetylene-based diols. The ceria-based CMP slurry may contain additional water-soluble polymers such as polysaccharides like alginic acid, pectin acid, carboxymethylcellulose, agar, curdlan, and pullulan; polycarboxylic acids such as polyaspartic acid, polyglutamic acid, polylysine, polymalic acid, polymethacrylic acid, polyimide acid, polymaleic acid, polyitaconic acid, polyfumaric acid, poly(p-styrene carboxylic acid), polyacrylic acid, polyacrylamide, amino polyacrylamide, polyglyoxalic acid and their salts; and vinyl polymers such as polyvinyl alcohol, and polyacrolein. The ceria-based CMP slurry is said to have a high silicon oxide over polysilicon selectivity.

The American patent application US 2007/0191244 A1 discloses a ceria-based CMP slurry containing a compound having a weight-average molecular weight of 30 to 500 and containing hydroxyl groups and a carboxyl group or both such as citrates, malates, gluconates, tartrates, 2-hydroxyisobutyrates, adipates, octanoates, succinates, EDTA-containing compounds, glutarates, methylenesuccinates, mannose, glycero-galacto-heptose, erythro-manno-octose, arabino-galacto-nonose, and glutamine. The ceria-based CMP slurry may furthermore contain linear polymer acids or graft type polymer acids having alkoxypolyalkylene glycol side chains. The ceria-based CMP slurry is said to achieve an improved global planarity of the polished wafers.

The American patent application US 2007/0218811 A1 discloses a ceria-based CMP slurry having a pH of 4 to 7.5 and containing a dispersing agent, a polycarboxylic acid, and 100 to 1000 ppm of a strong acid having a pKa of its first dissociable acidic group at 3.2 or less. By way of examples, polymers of acrylic acid and methacrylic acid are mentioned as anionic dispersing agents, polyoxyethylene derivatives are mentioned as nonionic dispersing agents, and polyvinylpyrrolidone is mentioned as a cationic dispersing agent. Specifically mentioned strong acids are sulfuric acid, HCl, nitric acid, phosphoric acid, oxalic acid, maleic acid, picric acid, sulfurous acid, thiosulfurous acid, amidosulfuric acid, chloric acid, perchloric acid, chlorous acid, hydroiodic acid, periodic acid, iodic acid, hydrobromic acid, perbromic acid, chromic acid, nitrous acid, diphosphonic acid, tripolyphosphoric acid, phosphinic acid, picolinic acid, phosphonic acid, isonicotinic acid, nicotinic acid, trichloroacetic acid, dichloroacetic acid, chloroacetic acid, cyanoacetic acid, oxaloacetic acid, nitroacetic acid, bromoacetic acid, fluoroacetic acid, phenoxyacetic acid, o-bromobenzoic acid, o-nitrobenzoic acid, o-chlorobenzoic acid, p-aminobenzoic acid, anthranilic acid, phthalic acid, fumaric acid, malonic acid, tartaric acid, citric acid, o-chloroaniline, 2,2'-bipyridine, 4,4'-bipyridine, 2,6-pyridinedicarboxylic acid, pyruvic acid, polystyrene sulfonic acid, polysulfonic acid, glutamic acid, salicylic acid, aspartic acid, 2-aminoethylphosphonic acid, lysine, arginine, isoleucine, sarcosine, ornithine, guanosine, citrulline, tyrosine, valine, hypoxanthine, methionine, lysine, and leucine. The ceria-based CMP slurry is to cause an efficient high-speed operation, an easier process management and a smaller fluctuation in film thickness due to difference in pattern density.

The American patent applications US 2008/0085602 A1 and US 2008/0124913 A1 disclose a ceria-based CMP slurry containing 0.001 to 0.1% by weight of the nonionic surfactant selected from ethyleneoxide-propyleneoxide-ethyleneoxide triblock copolymers and polyacrylic acid as dispersing agent. The ceria-based slurry he said to have a high silicon oxide and silicon nitride over polysilicon selectivity.

The fabrication of electrical devices, in particular, semiconductor integrated circuits (ICs); requires high precision methods which involve inter alia high selectivity CMP.

WO 2009/098924 A1 discloses an aqueous dispersion for chemical mechanical polishing, which contains silica particles (A) and an organic acid (B1). The silica particles have such chemical properties that the sodium, potassium and ammonium ion contents determined by the elemental analysis by ICP emission spectrometry or ICP mass spectrometry and the quantitative analysis of ammonium ions by ion chromatography are as follows: the sodium content is within the range of 5-500 ppm; and the content of at least one of potassium and ammonium ions is within the range of 100-20,000 ppm.

US 5 759 917 A discloses a composition for oxide CMP comprising a carboxylic acid, a salt and a soluble cerium compound at a pH above 3 and a method to selectively polish a silicon oxide overfill in preference to a silicon nitride film layer in a single step during the manufacture of integrated circuits and semiconductors.

WO 2009/107986 A1 discloses an aqueous slurry composition for chemical mechanical polishing that can show good polishing rate to the target layer, and yet has a high polishing selectivity and can maintain superior surface condition of the target layer after polishing, and a chemical mechanical polishing method. The aqueous slurry composition includes abrasives; an oxidant; a complexing agent; and a polymeric additive including at least one selected from the group consisting of a polypropyleneoxide, a propyleneoxide-ethyleneoxide copolymer.

US 2010/0151684 A1 comprises a slurry composition for primary chemical mechanical polishing that can show improved WIWNU (Within Wafer Non-Uniformity) while exhibiting excellent polishing rate and polishing selectivity, and a chemical mechanical polishing method. The slurry composition comprises an abrasive; an oxidant, an organic acid; a specific corrosion inhibitor, and, a polymeric additive comprising polyvinylpyrrolidone having weight average molecular weight of about 3000 to 100000, and has polishing selectivity of polishing rates between a copper layer: a tantalum layer of about 30: 1 or more.

EP 1 369 906 A1 discloses a polishing compound containing particles and a medium in which at least a part of the particles are dispersed, wherein the particles comprise at least one of (1) a cerium compound being selected from among a cerium oxide, a cerium halide and cerium sulfide and having a density of 3 to 6 g/cm³ and an average particle diameter of secondary particles of 1 to 300 nm and (2) a hydroxide of a tetravalent metal; and a method for polishing a substrate using the polishing compound.

Although the prior art ceria-based CMP slurries may have a satisfactory oxide-to-nitride selectivity and may yield polished wafers having a good global and local planarity as exemplified by the within-wafer nonuniformity (WIWNU) and the wafer-to-wafer nonuniformity (WTWNU), the ever decreasing dimensions of the IC architectures, in particular ICs with LSI (large-scale integration) or VLSI (very-large-scale integration), necessitate the constant improvement of the ceria-based CMP slurries in order to and meet the ever increasing technical and economical demands of the manufacturers of integrated circuit devices.

However, this pressing need to constantly improve the prior art ceria-based CMP slurries does not only apply to the field of integrated circuit devices, but the polishing and planarization efficacy has also to be improved in the fields of manufacturing other electrical devices such as liquid crystal panels, organic electroluminescent panels, printed circuit boards, micro machines, DNA chips, micro plants, photovoltaic cells, and magnetic heads; as well as high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks. The manufacturing of such electrical and optical devices also requires high precision CMP process steps.

### Objects of the Invention

Therefore, it is an object of the present invention to provide a novel aqueous polishing composition, in particular a novel chemical mechanical polishing (CMP) composition, especially a novel ceria-based CMP slurry, which no longer exhibits the disadvantages and drawbacks of the prior art polishing compositions.

In particular, the novel aqueous polishing composition, in particular the novel chemical mechanical polishing (CMP) composition, especially the novel ceria-based CMP slurry, should exhibit a significantly improved oxide-to-nitride selectivity and yield polished wafers having an excellent global and local planarity as exemplified by the within-wafer nonuniformity (WIWNU) and the wafer-to-wafer nonuniformity (WTWNU). Therefore, they should be excellently suited for manufacturing IC architectures, in particular ICs with LSI (large-scale integration) or VLSI (very-large-scale integration), having structures with dimensions below 50 nm.

Moreover, the novel aqueous polishing composition, in particular the novel chemical mechanical polishing (CMP) composition and especially the novel ceria-based CMP slurry should not only be exceptionally useful in the field of integrated circuit devices, but should also be most efficiently and advantageously useful in the fields of manufacturing other electrical devices such as liquid crystal panels, organic electroluminescent panels, printed circuit boards, micro machines, DNA chips, micro plants and magnetic heads; as well as high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks.

It is a further object of the present invention to provide a novel process for polishing substrate materials for mechanical, electrical and optical devices, the said substrate materials containing silicon oxide dielectric films and silicon nitride films.

### Summary of the Invention

Accordingly, the novel aqueous polishing composition has been found, comprising
(A) at least one type of abrasive inorganic particles (A) contain or consist of ceria which are positively charged when dispersed in an aqueous medium having a pH in the range of from 3 to 9 as evidenced by the electrophoretic mobility;
(B) at least one water-soluble and water-dispersible hydroxy group containing component selected from the group consisting of
   (b1) aliphatic and cycloaliphatic hydroxycarboxylic acids having at least three carbon atoms, at least two hydroxy groups and at least one carboxylic acid group to the molecule, wherein the molar ratio of hydroxy groups to carboxylic acid groups is at least 2;
   (b2) esters of the hydroxycarboxylic acids (b1) having at least one group selected from the group consisting of lactone groups, esterified hydroxy groups, esterified carboxylic acid groups and mixtures thereof, with the proviso that at least two hydroxy groups are present in (b2); and
   (b3) mixtures thereof; and
(C) at least one water-soluble and water-dispersible polymer component selected from the group consisting of
   (c1) linear and branched alkylene oxide homopolymers and copolymers selected from the group consisting of ethyleneoxide and propyleneoxide homopolymers and copolymers and mixtures thereof;
   and
   (c3) cationic polymeric flocculants having a weight average molecular weight of less than 100,000 Dalton selected from the group consisting of cationically modified polyacrylamides, polyamines, polyethyleneimines, poly(diallyl-N,N-dialylammonium halide) and mixtures thereof.
wherein (B) is selected from the group consisting of quinic acid, glucono-δ-lactone, glucuronic acid, lactobinonic acid and mixture thereof,
and wherein the composition has a pH in the range of from 2.5 to 4.

Hereinafter, the novel aqueous polishing composition is referred to as the "composition of the invention".

Moreover, the novel process for polishing substrate materials for mechanical, electrical and optical devices by contacting the substrate material at least once with the composition of the invention and polishing the substrate material until the desired planarity is achieved, has been found.

Hereinafter, the novel process for polishing substrate materials for mechanical, electrical and optical devices is referred to as the "process of the invention".

Additionally, the novel use of the composition of the invention for manufacturing electrical, mechanical and optical devices and the novel use of cationically modified flocculants for the stabilization of aqueous dispersions of particles have been found, which uses are hereinafter referred to as the "uses of the invention".

### Advantages of the Invention

In view of the prior art, it was surprising and could not be expected by the skilled artisan that the objects of the present invention could be solved by the composition of the invention, the process and the uses of the invention.

It was particularly surprising that the composition of the invention exhibited a significantly improved oxide-to-nitride selectivity and yield polished wafers having an excellent global and local planarity as exemplified by the within-wafer nonuniformity (WIWNU) and the wafer-to-wafer nonuniformity (WTWNU). Therefore, they were excellently suited for manufacturing IC architectures, in particular ICs with LSI (large-scale integration) or VLSI (very-large-scale integration), having structures with dimensions below 50 nm.

Additionally, the composition of the invention was stable during prolonged transport and storage, which stability significantly improved the logistics and the process management.

Moreover, the composition of the invention was not only exceptionally useful in the field of integrated circuit devices, but was also most efficiently and advantageously useful in the fields of manufacturing other electrical devices such as liquid crystal panels, organic electroluminescent panels, printed circuit boards, micro machines, DNA chips, micro plants and magnetic heads; as well as high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks.

Most particularly, the composition of the invention was exceptionally well-suited for the uses of the invention.

Therefore, the composition of the invention was most particularly useful for the process of the invention. The process of invention could be most advantageously used for polishing, in particular chemically mechanically polishing, substrate materials for electrical devices such as liquid crystal panels, organic electroluminescent panels, printed circuit boards, micro machines, DNA chips, micro plants and magnetic heads; as well as substrate materials for high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks.

Most particularly however, the process of the invention was excellently suited for polishing semiconductor wafers containing silicon oxide dielectric films and silicon nitride films. The process of the invention yielded polished wafers having an excellent global and local planarity and balance without dishing, cupping or hotspots as exemplified by the within-wafer nonuniformity (WIWNU) and the wafer-to-wafer nonuniformity (WTWNU). Therefore, they were excellently suited for manufacturing IC architectures, in particular ICs with LSI (large-scale integration) or VLSI (very-large-scale integration), having structures with dimensions below 50 nm.

### Detailed Description of the Invention

The composition of the invention is an aqueous composition. This means that it contains water, in particular ultrapure water, as the main solvent and dispersing agent. Nevertheless, the composition of the invention may contain at least one water-miscible organic solvent, however, only in such minor amounts that they do not change the aqueous nature of the composition of the invention.

Preferably, the composition of the invention contains water in amounts of from 60 to 99.95% by weight, more preferably 70 to 99.9% by weight, even more preferably 80 to 99.9% by weight and, most preferably, 90 to 99.9% by weight, the weight percentages being based on the complete weight of the composition of the invention.
"Water-soluble" means that the relevant component or ingredient of the composition of the invention can be dissolved in the aqueous phase on the molecular level.

"Water-dispersible" means that the relevant component or ingredient of the composition of the invention can be dispersed in the aqueous phase and forms a stable emulsion or suspension.

"Polymer" or "polymeric" means that the relevant component or ingredient of the composition of the invention consists of more than 12 linked monomeric structural units which all may have the same structure. However, it is also possible that the structural units are selected from at least two different structures.

The first essential ingredient of the composition of the invention is at least one, preferably one, type of abrasive particles (A).

The abrasive particles (A) are positively charged when the dispersed in an aqueous medium having a pH in the range of from 3 to 9. The positive charge is evidenced by the electrophoretic mobility µ (µm/s) (V/cm) of the abrasive particles (A). The electrophoretic mobility µ can be directly measured with instruments such as Zetasizer Nano from Malvern, Ltd.

The average particle size of the abrasive particles (A) can vary broadly and, therefore, can be adjusted most advantageously to the particular requirements of a given composition and process of the invention. Preferably, the average particle size as determined by dynamic laser light scattering is in the range of from 1 to 2000 nm, preferably 1 to 1000 nm, more preferably 1 to 750, and, most preferably, 1 to 500 nm.

The particle size distribution of the abrasive particles (A) can be monomodal, bimodal or multimodal. Preferably, the particle size distribution is monomodal in order to have an easily reproducible property profile of the abrasive particles (A) and easily reproducible conditions during the process of the invention.

Moreover, the particle size distribution of the abrasive particles (A) can be narrow or broad. Preferably, the particle size distribution is narrow with only small amounts of small particles and large particles in order to have an easily reproducible property profile of the abrasive particles (A) and easily reproducible conditions during the process of the invention.

The abrasive particles (A) can have various shapes. Thus, they may be of one or essentially one type of shape. However, it also possible that the abrasive particles (A) have different shapes. In particular, two types of differently shaped abrasive particles (A) may be present in a given composition of the invention. As regards the shapes themselves, they can be cubes, cubes with chamfered edges, octahedrons, icosahedrons, nodules and spheres with or without protrusions or indentations. Most preferably, the shape is spherical with no or only very few protrusions or indentations. This shape, as a rule, is preferred because it usually increase is the resistance to the mechanical forces the abrasive particles (A) are exposed to it during a CMP process.

The inorganic abrasive particles (A) containing or consisting of ceria are used.

The abrasive particles (A) which contain ceria can contain minor amounts of other rare earth metal oxides.

Preferably, the abrasive particles (A) which contain ceria are composite particles (A) comprising a core containing or consisting of at least one other abrasive particulate material which is different from ceria, in particular alumina, silica titania, zirconia, zinc oxide, and mixtures thereof.

Such composite particles (A) are known, for example, from WO 2005/035688 A1, US 6,110,396, US 6,238,469 B1, US 6,645,265 B1, K. S. Choi et al., Mat. Res. Soc. Symp. Proc. Vol. 671, 2001 Materials Research Society, M5.8.1 to M5.8.10, S.-H. Lee et al., J. Mater. Res., Vol. 17, No. 10, (2002), pages 2744 to 2749, A. Jindal et al., Journal of the Electrochemical Society, 150 (5) G314-G318 (2003), Z. Lu, Journal of Materials Research, Vol. 18, No. 10, October 2003, Materials Research Society, or S. Hedge et al., Electrochemical and Solid-State Letters, 7 (12) G316-G318 (2004).

Most preferably, the composite particles (A) are raspberry-type coated particles comprising a core selected from the group consisting of alumina, silica titania, zirconia, zinc oxide, and mixtures thereof with a core size of from 20 to 100 nm wherein the core is coated with ceria particles having a particle size below 10 nm.

The amount of the abrasive particles (A) used in the composition of the invention can vary broadly and, therefore, can be adjusted most advantageously to the particular requirements of a given composition and process of the invention. Preferably, the composition of the invention contains 0.005 to 10% by weight, more preferably 0.01 to 8% by weight and, most preferably 0.01 to 6% by weight of the abrasive particles (A), the weight percentages being based on the complete weight of the composition of the invention.

The composition of the invention contains at least one, preferably one, water-soluble or water dispersible, preferably, water-soluble, hydroxy group containing component (B) as the second essential ingredient.

The component (B) is selected from the group consisting of
(b1) aliphatic and cycloaliphatic hydroxycarboxylic acids having
   - at least two, preferably at least three, more preferably at least four, even more preferably at least five and most preferably at least six carbon atoms,
   - at least one, preferably at least two, more preferably at least three and, most preferably, at least four hydroxy group and
   - at least one carboxylic acid group
   to the molecule, wherein the molar ratio of hydroxy groups to carboxylic acid groups is at least 1, preferably at least 2, more preferably at least 3 and, most preferably, at least 4;
(b2) esters of the hydroxycarboxylic acids (b1) having at least one group selected from the group consisting of lactone groups, esterified hydroxy groups, esterified carboxylic acid groups and mixtures thereof, with the proviso that at least one, hydroxy group, preferably at least two and, most preferably, at least three hydroxy groups is or are present in (b2); and
(b3) mixtures thereof.

The component (B) is selected from the group consisting of quinic acid, glucuronic acid, lactobionic acid, glucono-delta-lactone and mixtures thereof.

The concentration of the component (B) in the composition of the invention can vary broadly and, therefore, can be most advantageously adapted to the particular requirements of a given composition and process of the invention. Preferably, the composition of the invention contains the component (B) in amounts of from to 0.005 is to 5% by weight, more preferably 0.01 to 4% by weight, and most preferably 0.01 to 3% by weight, the weight percentages being based on the complete weight of the composition of the invention.

As the third essentially ingredient, the composition of the invention contains at least one, preferably two, water-soluble or water-dispersible, preferably water-soluble, is selected from the group consisting of polymer component(s) (C).

The component (C) is selected from the group consisting of
(c1) linear and branched alkylene oxide homopolymers and copolymers selected from the group consisting of ethyleneoxide and propyleneoxide homopolymers and copolymers and mixtures thereof;;
; and
(c3) cationic polymeric flocculants having a weight average molecular weight of less than 100,000, preferably less than 75,000, even more preferably less than 50,000, and most preferably less than 30,000 Dalton.

The alkylene oxide homopolymer or copolymer (c1) is selected from the group consisting of linear and branched ethyleneoxide and propyleneoxide homopolymers and copolymers.

The ethyleneoxide-propyleneoxide copolymers (c1) can be random copolymers, alternating copolymers or blockcopolymers containing polyethyleneoxide blocks and polypropyleneoxide blocks. In the ethyleneoxide-propyleneoxide blockcopolymers (c1), the polyethyleneoxide blocks preferably have hydrophile-lipophile-balance (HLB) values from 10 to 15. The polypropyleneoxide blocks may preferably have a HLB values of from 28 to about 32.

Preferably, the alkylene oxide homopolymers (c1) are ethyleneoxide polymers, such as polyethylene glycol (PEG).

Preferably, the water-soluble polymers (c1) have a weight average molecular weight of from 2000 to 1,000,000 Dalton, more preferably 5000 to 500,000 Dalton and, most preferably, 10,000 to 250,000 Dalton.

The water-soluble polymers (c1) are customary and known, commercially available materials. Suitable water-soluble polymers (c1) are described in the Japanese patent application JP 2001-240850 A, claim 2 in conjunction with the paragraphs [0007] to [0014], the American patent application US 2007/0077865 A1, column page 1, paragraph [0008] to page 2, paragraph [0010], the American patent application US 2006/0124594 A1, page 3, paragraphs [0036] and [0037] and the American patent application US 2008/0124913 A1, page 3, paragraphs [0031] to [0033] in conjunction with the claim 14 or they are sold under the trademarks Pluronic™, Tetronic™ and Basensol™ by BASF Corporation and BASF SE as evidenced by the company brochure of BASF Corporation "Pluronic™ & Tetronic™ Block Copolymer Surfactants, 1996" or the American patent US 2006/0213780 A1.

Most preferably, polyethylene glycol (PEG) is used as the polymer (c1).

Preferably, the cationic polymeric flocculant (c3) is selected from the group consisting of cationically modified polyacrylamides, polyamines, polyethyleneimines, poly(diallyl-N,N-dialkylammonium halide) and mixtures thereof.

More preferably, the cationic groups are selected from the group consisting of quaternary ammonium groups, sulfonium groups, phosphonium groups and mixtures thereof. Most preferably, quaternary ammonium groups are used.

More preferably, the alkyl group of the poly(diallyl-N,N-dialkylammonium halide) (c3) is selected from the group consisting of methyl, ethyl, propyl and isopropyl and mixtures thereof. Most preferably, methyl groups are used. More preferably, the halide is selected from the group consisting of fluoride, chloride and bromide. Most preferably, chloride is used. Most preferably, poly(diallyl-N,N-dimethylammonium chloride) (poly-DADMAC) is used.

The concentration of the cationically modified flocculant (c3) in the composition of the invention can vary broadly and, therefore, can be adapted most advantageously to the particular requirements of a given composition and process of the invention. Preferably, the flocculant (c3) is used in amounts of from 0.0001 to 1% by weight, preferably 0.0002 to 1% by weight, and most preferably 0.0003 to 1% by weight, the weight percentages being based on the complete weight of the composition of the invention.

The cationically modified flocculants (c3) are customary and known materials which are commercially available, for example, from BASF SE under the trademark Sedipur™ C.

It was most surprising that, according to one of the uses of the invention, the cationically modified flocculants (c3) can be used to stabilize the aqueous dispersions of the abrasive particles (A).

The composition of the invention can contain at least one functional component (D) which is materially different from the ingredients (A), (B) and (C).

Preferably, the functional component (D) is selected from the group of compounds customarily used in ceria-based CMP slurries.

Examples of such compounds (D) are disclosed in, for example, by Y. N. Prasad et al. in Electrochemical and Solid-State Letters, 9 (12) G337-G339 (2006), Hyun-Goo Kang et al. in Journal of Material Research, volume 22, No. 3, 2007, pages 777 to 787, S. Kim et al. in Journal of Colloid and Interface Science, 319 (2008), pages 48 to 52, S. V. Babu et al. in Electrochemical and Solid-State Letters, 7 (12) G327-G330 (2004), Jae-Dong Lee et al. in Journal of the Electrochemical Society, 149 (8) G477-G481, 2002, the American patents US 5,738,800, US 6, 042, 741, US 6,132,637, US 6,218,305 B, US 5,759,917, US 6,689,692 B1, US 6,984,588 B2, US 6,299,659 B1, US 6,626,968 B2, US 6,436,835, B1 US 6,491,843 B1, US 6,544,892 B2, US 6,627,107 B2, US 6,616,514 B1, and US 7,071,105 B2, the American patent applications US 2002/0034875 A1, US 2006/0144824 A1, US 2006/0207188 A1, US 2006/0216935 A1, US 2007/0077865 A1, US 2007/0175104 A1, US 2007/0191244 A1 and US 2007/0218811 A1, and the Japanese patent application JP 2005-336400 A.

Moreover, the functional component (D) is selected from the group consisting of organic, inorganic and hybrid organic-inorganic abrasive particles being different from the particles (D), polyhydric alcohols with at least two hydroxy groups, materials having a lower critical solution temperature LCST or an upper critical solution temperature UCST, oxidizing agents, passivating agents, charge reversal agents, complexing or chelating agents, frictive agents, stabilizing agents, rheology agents, surfactants, metal cations and organic solvents.

Suitable organic abrasive particles (D) and their effective amounts are known, for example, from the American patent application US 2008/0254628 A1, page 4, paragraph [0054] or from the international application WO 2005/014753 A1, wherein solid particles consisting of melamine and melamine derivatives such as acetoguanamine, benzoguanamine and dicyandiamide are disclosed.

Suitable inorganic abrasive particles (D) and their effective amounts are known, for example, from the international patent application WO 2005/014753 A1, page 12, lines 1 to 8 or the American patent US 6,068,787, column 6, line 41 to column 7, line 65.

Suitable hybrid organic-inorganic abrasive particles (D) and their effective amounts are known, for example, from the American patent applications US 2008/0254628 A1, page 4, paragraph [0054] or US 2009/0013609 A1, page 3, paragraph [0047] to page 6, paragraph [0087].

Suitable polyhydric alcohols (D) are diols such as ethylene glycol and propylene glycol, triols such as glycerol, pentaerythritol, alditols, cyclitols and dimers and oligomers of glycerol, trimethylolpropane, pentaerythritol, alditols and cyclitols.

Suitable oxidizing agents (D) and their effective amounts are known, for example, from the European patent application EP 1 036 836 A1, page 8, paragraphs [0074] and [0075] or from the American patents US 6,068,787, column 4, line 40 to column 7, line 45 or US 7,300,601 B2, column 4, lines 18 to 34. Preferably, organic and inorganic peroxides, more preferably inorganic peroxides, are used. In particular, hydrogen peroxide is used.

Suitable passivating agents (D) and their effective amounts are known, for example, from the American patent US 7,300,601 B2, column 3, line 59 to column 4, line 9 or from the American patent application US 2008/0254628 A1, the paragraph [0058] bridging the pages 4 and 5.

Suitable complexing or chelating agents (D), which are sometimes also designated as frictive agents (cf. the American patent application US 2008/0254628 A1, page 5, paragraph [0061]) or etching agents or etchants (cf. the American patent application US 2008/0254628 A1, page 4, paragrap [0054]), and their effective amounts are known, for example, from the American patent US 7,300,601 B2, column 4, lines with 35 to 48. The amino acids, in particular glycine, and, moreover, dicyandiamide and triazines containing at least one, preferably two and, more preferably, three primary amino groups such as melamine and water-soluble guanamines, particularly melamine, formoguanamine, acetoguanamine and 2,4-diamino-6-ethyl-1,3,5-triazine, are most particularly preferably used.

Suitable stabilizing agents (D) and their effective amounts are known, for example, from the American patent US 6,068,787, column 8, lines 4 to 56.

Suitable rheology agents (D) and their effective amounts are known, for example, from the American patent application US 2008/0254628 A1, page 5, paragraph [0065] to page 6, paragraph [0069].

Suitable surfactants (D) and their effective amounts are known, for example, from the international patent application WO 2005/014753 A1, page 8, line 23, to page 10, line 17 or from the American patent US 7,300,601 B2, column 5, line 4 to column 6, line 8.

Suitable polyvalent metal ions (D) and their effective amounts are known, for example, from the European patent application EP 1 036 836 A1, page 8, paragraph [0076] to page 9, paragraph [0078].

Suitable organic solvents (D) and their effective amounts are known, for example, from the American patent US 7,361,603 B2, column 7, lines 32 to 48 or the American patent application US 2008/0254628 A1, page 5, paragraph [0059].

Suitable materials (D) exhibiting a lower critical solution temperature LCST or an upper critical solution temperature UCST are described, for example, in the article of H. Mori, H. Iwaya, A. Nagai and T. Endo, Controlled synthesis of thermoresponsive polymers derived from L-proline via RAFT polymerization, in Chemical Communication, 2005, 4872-4874; or in the article of D. Schmaljohann, Thermo- and pH-responsive polymers and drug delivery, Advanced Drug Delivery Reviews, volume 58 (2006), 1655-1670 or in the American patent applications US 2002/0198328 A1, US 2004/0209095 A1, US 2004/0217009 A1, US 2006/0141254 A1, US 2007/0029198 A1, US 2007/0289875 A1, US 2008/0249210 A1, US 2008/0050435 A1 or US 2009/0013609 A1, the American patents US 5,057,560, US 5,788,82 and US6,682,642 B2, the international patent applications WO 01/60926 A1, WO2004/029160 A1, WO 2004/0521946 A1, WO 2006/093242 A2 or WO 2007/012763 A1, in the European patent applications EP 0 583 814 A1, EP 1 197 587 B1 and EP 1 942 179 A1, or the German patent application DE 26 10 705.

In principle, any known charge reversal agent (D) customarily used in the field of CMP can be used. Preferably, the charge reversal agent (D) is selected from the group consisting of monomeric, oligomeric and polymeric compounds containing at least one anionic group selected from the group consisting of carboxylate, sulfonate, sulfate and phosphonate groups.

If present, the functional component (D) can be contained in varying amounts. Preferably, the total amount of (D) is not more than 10 wt.% ("wt.%" means "percent by weight"), more preferably not more than 2 wt.%, most preferably not more than 0.5 wt.%, particularly not more than 0.1 wt.%, for example not more than 0.01 wt.%, based on the total weight of the corresponding CMP composition. Preferably, the total amount of (D) is at least 0.0001 wt.%, more preferably at least 0.001 wt.%, most preferably at least 0.008 wt.%, particularly at least 0.05 wt.%, for example at least 0.3 wt.%, based on the total weight of the corresponding composition.

The composition of the invention can optionally contain at least one pH-adjusting agent or buffering agent (E) which is materially different from the ingredients (A), (B) and (C).

Suitable pH-adjusting agents or buffering agents (E) and their effective amounts are known, for example, from the European patent application EP 1 036 836 A1, page 8, paragraphs [0080], [0085] and [0086], the international patent application WO 2005/014753 A1, page 12, lines 19 to 24, the American patent application US 2008/0254628 A1, page 6, paragraph [0073] or the American patent US 7,300,601 B2, column 5, lines 33 to 63. Examples for pH-adjusting agents or buffering agents (E) are potassium hydroxide, ammonium hydroxide, tetramethylammonium hydroxide (TMAH), nitric acid, and sulfuric acid.

If present, the pH-adjusting agent or buffering agent (E) can be contained in varying amounts. Preferably, the total amount of (E) is not more than 20 wt.%, more preferably not more than 7 wt.%, most preferably not more than 2 wt.%, particularly not more than 0.5 wt.%, for example not more than 0.1 wt.%, based on the total weight of the corresponding CMP composition. Preferably, the total amount of (E) is at least 0.001 wt.%, more preferably at least 0.01 wt.%, most preferably at least 0.05 wt.%, particularly at least 0.1 wt.%, for example at least 0.5 wt.%, based on the total weight of the corresponding composition.

The pH of the composition of the invention is set between 2.5 and 4, preferably using the aforementioned pH-adjusting agents (E).

The preparation of the composition of the invention does not exhibit any particularities but can be carried out by dissolving or dispersing the above-described ingredients (A), (B) and (C) and optionally (D) and/or (E) in an aqueous medium, in particular, de-ionized water. For this purpose, the customary and standard mixing processes and mixing apparatuses such as agitated vessels, in-line dissolvers, high shear impellers, ultrasonic mixers, homogenizer nozzles or counterflow mixers, can be used. Preferably, the composition of the invention thus obtained can be filtered through filters of the appropriate mesh aperture, in order to remove coarse-grained particles such as the agglomerates or aggregates of the solid, finely dispersed abrasive particles (A).

The compositions of the invention are excellently suited for the process of the invention.

In the process of the invention, a substrate material for electrical, mechanical and optical devices, in particular, electrical devices, most preferably, integrated circuit devices, is contacted at least once with a composition of the invention and polished, in particular, chemically and mechanically polished, until the desired planarity is achieved.

The process on the invention exhibits its particular advantages in the CMP of silicon semiconductor wafers having isolating layers consisting of low-k or ultra-low-k silicon oxide materials and silicon nitride layers as stopping or barrier layers.

Suitable low-k or ultra-low-k materials and suitable methods of preparing the insulating dielectric layers are described in, for example, the American patent applications US 2005/0176259 A1, page 2, paragraphs [0025] to [0027], US 2005/0014667 A1, page 1, paragraph [0003], US 2005/0266683 A1, page 1, paragraph [0003] and page 2, paragraph [0024] or US 2008/0280452 A1, paragraphs [0024] to [0026] or in the American patent US 7,250,391 B2, column 1, lines 49 to 54 or in the European patent application EP 1 306 415 A2, page 4, paragraph [0031].

The process of the invention is particularly suited for the shallow trench isolation (STI) which requires the selective removal of silicon dioxide over silicon nitride on a patterned wafer substrate. In this process, etched trenches are overfilled with the dielectric material, e.g., silicon dioxide, which is polished using the silicon nitride barrier film as the stopping layer. In this preferred embodiment, the process of the invention ends with clearing the silicon dioxide from the barrier film while minimizing the removal of exposed silicon nitride and trench silicon oxide.

Thus, the process of the invention exhibits an oxide-to-nitride selectivity greater than 50, preferably greater than 75 and most preferably greater than 100.

The process of the invention exhibits no particularities but can be carried out with the processes and the equipment customarily used for the CMP in the fabrication of semiconductor wafers with ICs.

As is known in the art, a typical equipment for the CMP consists of a rotating platen which is covered with a polishing pad. The wafer is mounted on a carrier or chuck with its upper side down facing the polishing pad. The carrier secures the wafer in the horizontal position. This particular arrangement of polishing and holding device is also known as the hard-platen design. The carrier may retain a carrier pad which lies between the retaining surface of the carrier and the surface of the wafer which is not being polished. This pad can operate as a cushion for the wafer.

Below the carrier, the larger diameter platen is also generally horizontally positioned and presents a surface parallel to that of the wafer to be polished. Its polishing pad contacts the wafer surface during the planarization process. During the CMP process of the invention, the composition of the invention is applied onto the polishing pad as a continuous stream or in dropwise fashion.

Both the carrier and the platen are caused to rotate around their respective shafts extending perpendicular from the carrier and the platen. The rotating carrier shaft may remain fixed in position relative to the rotating platen or may oscillate horizontally relative to the platen. The direction of rotation of the carrier typically, though not necessarily, is the same as that of the platen. The speeds of rotation for the carrier and the platen are generally, though not necessarily, set at different values.

Customarily, the temperature of the platen is set at temperatures between 10 and 70°C.

For further details reference is made to the international patent application WO 2004/063301 A1, in particular page 16, paragraph [0036] to page 18, paragraph [0040] in conjunction with the figure 1.

By way of the process of the invention semiconductor wafers with ICs comprising patterned low-k and ultra-low-k material layers, in particular silicon dioxide layers, having an excellent planarity can be obtained. Therefore, copper damascene patterns can be obtained which also have an excellent planarity and, in the finished, IC an excellent electrical functionality.

### Examples and Comparative Experiments

### Comparative Experiments C1 to C5

### CMP of Silicon Oxide Coated and Silicon Nitride Coated Blanket Wafers with the Comparative Aqueous Polishing Compositions C1 to C5 and Oxide-to Nitride Selectivities

The compositions of the comparative aqueous polishing compositions C1 to C5 are compiled in the Table 1.

**Table 1: The Compositions of the Comparative Aqueous Polishing Compositions C1 to C5**

| Composition No. | Ceria^{a)}/% by weight | Quinic Acid/% by weight | Glucono-delta-Lactone/% by weight | Glucuronic Acid/% by weight | Lactobionic Acid/% by weight | pH |
|---|---|---|---|---|---|---|
| C1 | 0.5 | - | - | - | - | 3 |
| C2 | 0.5 | 0.05 | - | - | - | 3 |
| C3 | 0.5 | - | 0.05 | - | - | 3 |
| C4 | 0.5 | - | - | 0.05 | - | 3 |
| C5 | 0.5 | - | - | - | 0.05 | 3 |

| | | | | | | |
|---|---|---|---|---|---|---|
| a) Average primary particle size as measured by dynamic laser light diffraction: 60 nm | | | | | | |

For the CMP, the following process parameters were used:
- Polishing apparatus: AMAT Mirra (rotary type):
- platen speed: 90 rpm;
- carrier speed: 70 rpm;
- IC 1000/Suba 400 K-groove polishing pad manufactured by Rohm & Haas;
- in situ conditioning using S60 3M diamond conditioner;
- slurry flow rate: 200 ml/min;
- substrates: 2000 nm thermal silicon dioxide coated blanket wafers from SKW and 500 nm silicon nitride coated blanket wafers from Montco Silicon; examples 20 to 22: TEOS silicon dioxide coated blanket wafers;
- down force: 3.5 psi (240 mbar);
- polishing time: 1 minute.

The material removal rates MRRs were measured with a reflectometer. The results obtained are compiled in the Table 2.

**Table 2: CMP of Silicon Dioxide Coated Blanket Wafers and Silicon Nitride Coated Blanket Wafers and Oxide-To-Nitride Selectivity**

| Comparative Experiment No. | Silicon Dioxide MRR^{a)} | Silicon Nitride MRR^{a)} | Oxide-To-Nitride Selectivity |
|---|---|---|---|
| C1 | 386 | 88 | 4 |
| C2 | 2984 | 67 | 45 |
| C3 | 2682 | 24 | 112 |
| C4 | 3234 | 14 | 234 |
| C5 | 3453 | 10 | 354 |

| | | | |
|---|---|---|---|
| a) Angstrom/minute | | | |

The results compiled in the Table 2 make apparent that high oxide-to-nitride selectivities could be achieved with the hydroxycarboxylic acids and the hydroxy groups containing lactone alone. However, the comparative aqueous polishing compositions containing only these additives needed considerable improvement with regard to dishing and overpolishing of trench oxide in the STI process and dispersion stability (potlife).

### Examples 1 to 3 and Comparative Experiments C6 and C7

### CMP of silicon oxide and silicon nitride blanket wafers and patterned wafers

The compositions of the aqueous polishing compositions of the examples 1 to 3 and of the comparative aqueous polishing compositions C6 and C7 are compiled in the Table 3.

**Table 3: The Compositions of the Aqueous Polishing Compositions 1 to 3 and of the Comparative Aqueous Polishing Compositions C6 and C7**

| Example or Comparative Composition No. | Ceria^{a)}/% by weight | Glucuronic Acid/% by weight | PEG^{b)}/% by weight | PVP^{c)}/% by weight | pH |
|---|---|---|---|---|---|
| C6 | 1 | 0.1 | - | - | 3 |
| 1 | 1 | 0.1 | 0.02 | - | 3 |
| 2 | 1 | 0.1 | 0.04 | - | 3 |
| C7 | 0.15 | 0.025 | - | - | 3 |
| 3 | 0,15 | 0.025 | 0.01 | - | 3 |

| | | | | | |
|---|---|---|---|---|---|
| a) Average particle size as measured by laser light diffraction: 60 nm; b) polyethylene glycol PEG_{10K} having an average molecular weight of 10,000 Dalton; | | | | | |

For the CMP, the following process parameters were used:
- Polishing apparatus in the the examples 1 and 2 and the comparative experiment C6: AMAT Mirra (rotary type);
- polishing apparatus in the examples 3 and 4 and the comparative experiment C7: Strasbaugh 6EG nHance;
- platen speed: 90 rpm;
- carrier speed: 70 rpm;
- IC 1000/Suba 400 K-groove polishing pad manufactured by Rohm & Haas;
- in situ conditioning using A160 diamond conditioner from Rohm & Haas or 3M;
- slurry flow rate: 200 ml/min;
- substrates: 2000 nm thermal silicon dioxide coated blanket wafers from SKW and 500 nm silicon nitride coated blanket wafers from Montco Silicon;
- down force: 3 psi (205 mbar).

The material removal rates (MRRs) were measured by Therma Wave Optiprobe 2600 and before and after CMP.

The initial topography or step height in silicon oxide-silicon nitride-field oxide patterned wafers STI 3-2 from SKW were polished using a commercially available CMP Slurry (Cabot SS25, 1:1 dilution), in order to "knock out" the topography. The applied down force was 5 psi (341.66 mbar). The aim of this P1 process was to achieve near planarization with a few amounts of oxide thickness left atop the silicon nitride stopping layer. The patterned wafer measurements were done on two sites, namely (i) at the active oxide site to measure the remaining oxide left and (ii) at the field oxide site to measure the trench oxide.

The blanket wafers were polished under the above-mentioned conditions. The material removal rates MRRs obtained were used to calculate the time to remove the active oxide left atop the silicon nitride stopping layer after the P1 process. This time was referred to as "endpoint (EP)" and any additional polishing time after the endpoint was referred to as "overpolishing (OP)".

The obtained results are compiled in the Table 4.

**Table 4: Overpolishing Behavior of the Aqueous Polishing Compositions of the Examples 1 to 3 and of the Comparative Experiments C6 and C7**

| Example or Comparative Experiment No. | Blanket Silicon Dioxide MRR^{a)} | Trench Oxide Consumption^{b)} (100 X 100 µm Feature) | | Dishing^{b)} (100 x 100 µm Feature) | |
|---|---|---|---|---|---|
| | | EP | 100% OP | EP | 100% OP |
| C6 | 2839 | 456 | 1920 | 280 | 1500 |
| 1 | 2929 | 381 | 1527 | 150 | 1260 |
| 2 | 2889 | 282 | 1468 | 150 | 1200 |
| C7 | 2850 | 224 | 713 | 377 | 865 |
| 3 | 2787 | 104 | 538 | 104 | 538 |

| | | | | | |
|---|---|---|---|---|---|
| a) Angstrom/minute b) Angstrom | | | | | |

The Table 4 makes apparent that the addition of the anti-dishing agent PEG_{10K} caused no significant difference in the blanket way for or active oxide MRR but considerably reduced the trench oxide consumption and dishing as compared with the comparative experiments C6 and C7.

### Example 5

### Stabilization of Ceria-Based Aqueous Polishing Compositions with Cationically Modified Flocculants

A cationically modified flocculant (Sedipur™ CL 520 from BASF SE) was added in various amounts to an aqueous polishing composition having a pH of 3 and containing 0.5% by weight ceria and 0.025% by weight of glucuronic acid. The average particle sizes were measured with a Horiba Instrument particle size analyzer. The obtained results are compiled in the Table 5.

**Table 5: The Stabilization of a Ceria-Based Aqueous Polishing Composition with Sedipur™ CL 520**

| Concentration of Sedipur™ CL 520/ppm | Initial Particle Size/nm | Particle Size/nm After 96 Hours |
|---|---|---|
| 0 | 106 | 1673 |
| 5 | 106 | 563 |
| 10 | 106 | 102 |
| 20 | 106 | 100 |
| 30 | 102 | 100 |
| 50 | 100 | 102 |
| 100 | 102 | 100 |
| 150 | 99 | 99 |
| 300 | 98 | 98 |

The Table 5 makes apparent that even the addition of such low amounts as 10 ppm was already enough to control the aggregation of the ceria particles thereby enhancing the stability of the aqueous polishing composition and its potlife.

### Example 6 and Comparative Experiment C8

### CMP with an Aqueous Polishing Composition with (Example 6) and without (Comparative Experiment C8) a Cationically Modified Flocculant and Oxide-To-Nitride Selectivities

An aqueous polishing composition having a pH of 3 and containing 0.5% by weight ceria and 0.025% by weight of glucuronic acid was used for the comparative experiment C8.

An aqueous polishing composition having a pH of 3 and containing 0.5% by weight ceria, 0.025% by weight of glucuronic acid and 70 ppm Sedipur™ CL 520 was used for the example 6.

Silicon dioxide coated blanket wafers and silicon nitride coated blanket wafers were polished as described hereinbefore in the comparative experiments C1 to C5.

The obtained results are compiled in Table 6.

**Table 6: CMP of Silicon Dioxide Coated Blanket Wafers and Silicon Nitride Coated Blanket Wafers and Oxide-To-Nitride Selectivity**

| Example or Comparative Experiment No. | Silicon Dioxide MRR^{a)} | Silicon Nitride MRR^{a)} | Oxide-To-Nitride Selectivity |
|---|---|---|---|
| C8 | 2570 | 14 | 183 |
| 6 | 2413 | 15 | 160 |

| | | | |
|---|---|---|---|
| a) Angstrom/minute | | | |

Table 6 makes apparent that the addition of Sedipur™ CL 520 did not affect the polishing results. However, the aqueous polishing composition of the example 6 exhibited a much longer potlife than be aqueous polishing composition of the comparative experiment C8.

## Claims

1. An aqueous polishing composition comprising
(A) at least one type of abrasive inorganic particles (A) contain or consist of ceria which are positively charged when dispersed in an aqueous medium having a pH in the range of from 3 to 9 as evidenced by the electrophoretic mobility;
(B) at least one water-soluble and water-dispersible hydroxy group containing component selected from the group consisting of
(b1) aliphatic and cycloaliphatic hydroxycarboxylic acids having at least three carbon atoms, at least two hydroxy groups and at least one carboxylic acid group to the molecule, wherein the molar ratio of hydroxy groups to carboxylic acid groups is at least 2;
(b2) esters of the hydroxycarboxylic acids (b1) having at least one group selected from the group consisting of lactone groups, esterified hydroxy groups, esterified carboxylic acid groups and mixtures thereof, with the proviso that at least two hydroxy groups are present in (b2); and
(b3) mixtures thereof; and
(C) at least one water-soluble and water-dispersible polymer component selected from the group consisting of
(c1) linear and branched alkylene oxide homopolymers and copolymers selected from the group consisting of ethyleneoxide and propyleneoxide homopolymers and copolymers and mixtures thereof;
(c2) and
(c3) cationic polymeric flocculants having a weight average molecular weight of less than 100,000 Dalton selected from the group consisting of cationically modified polyacrylamides, polyamines, polyethyleneimines, poly(diallyl-N,N-dialylammonium halide) and mixtures thereof.
wherein (B) is selected from the group consisting of quinic acid, glucono-δ-lactone, glucuronic acid, lactobinonic acid and mixture thereof,
and wherein the composition has a pH in the range of from 2.5 to 4.

2. The aqueous polishing composition according to claim 1, **characterized in that** it contains at least one functional component (D) different from the components (A), (B) and (C), and the functional component (D) is selected from the group consisting of organic, inorganic and hybrid organic-inorganic abrasive particles being different from the particles (A), plyhdric alcohols having at least two hydroxy groups, materials having a lower critical solution temperature LCST or an upper critical solution temperature UCST, oxidizing agents, passivating agents, charge reversal agents, complexing or chelating agents, frictive agents, stabilizing agents, rheology agents, surfactants, metal cations and organic solvents.

3. The aqueous polishing composition according to anyone of the claims 1 to 2, **characterized in that** it contains at least one pH-adjusting agent or buffering agent (E) different from the components (A), (B) and (C).

4. A process for polishing substrate materials for electrical, mechanical and optical devices by contacting the substrate material at least once with an aqueous polishing composition and polishing the substrate material until the desired planarity is achieved, **characterized in that** the aqueous polishing composition according to anyone of the claims 1 to 3 is used.

5. The process according to claim 4, **characterized in that** the substrate material comprises at least one layer containing or consisting of at least one dielectric silicon oxide material and at least one layer containing or consisting of silicon nitride.

6. The process according to anyone of the claims 4 to 5, **characterized in that** the electrical devices are integrated circuit devices which contain integrated circuits with large-scale integration or very-large-scale integration having structures with dimensions below 50 nm.

7. The use of the aqueous polishing composition according to anyone of the claims 1 to 3 for manufacturing electrical, mechanical and optical devices.

8. The use of cationically modified flocculants (c3) having a weight average molecular weight of less than 100,000 Dalton for the stabilization of dispersions containing at least one type of abrasive particles (A) which are positively charged when dispersed in an aqueous medium having a pH in the range of from 3 to 9 as evidenced by the electrophoretic mobility.

## Patentansprüche

1. Wässrige Polierzusammensetzung, umfassend
(A) mindestens einen Typ von anorganischen Schleifteilchen (A), die Ceroxid enthalten oder aus Ceroxid bestehen und bei Dispergierung in einem wässrigen Medium mit einem pH-Wert von 3 bis 9 gemäß der elektrophoretischen Mobilität positiv geladen sind;
(B) mindestens eine wasserlösliche und wasserdispergierbare hydroxylgruppenhaltige Komponente aus der Gruppe bestehend aus
(b1) aliphatischen und cycloaliphatischen Hydroxycarbonsäuren mit mindestens drei Kohlenstoffatomen, mindestens zwei Hydroxygruppen und mindestens einer Carbonsäuregruppe pro Molekül, wobei das Molverhältnis von Hydroxygruppen zu Carbonsäuregruppen mindestens 2 beträgt;
(b2) Estern der Hydroxycarbonsäuren (b1) mit mindestens einer Gruppe aus der Gruppe bestehend aus Lactongruppen, veresterten Hydroxygruppen, veresterten Carbonsäuregruppen und Mischungen davon, mit der Maßgabe, dass in (b2) mindestens zwei Hydroxygruppen vorliegen; und
(b3) Mischungen davon; und
(C) mindestens eine wasserlösliche und wasserdispergierbare Polymerkomponente aus der Gruppe bestehend aus
(c1) linearen und verzweigten Alkylenoxid-Homopolymeren und -Copolymeren aus der Gruppe bestehend aus Ethylenoxid- und Propylenoxid-Homopolymeren und -Copolymeren und Mischungen davon;
(c2) und
(c3) kationischen polymeren Flockungsmitteln mit einem gewichtsmittleren Molekulargewicht von weniger als 100.000 Dalton aus der Gruppe bestehend aus kationisch modifizierten Polyacrylamiden, Polyaminen, Polyethyleniminen, Poly(diallyl-N,N-diallylammoniumhalogenid) und Mischungen davon;
wobei (B) aus der Gruppe bestehend aus Chinasäure, Glucono-δ-lacton, Glucuronsäure, Lactobionsäure und Mischungen davon ausgewählt ist
und wobei die Zusammensetzung einen pH-Wert im Bereich von 2,5 bis 4 aufweist.

2. Wässrige Polymerzusammensetzung nach Anspruch 1, **dadurch gekennzeichnet, dass** sie mindestens eine funktionelle Komponente (D), die von den Komponenten (A), (B) und (C) verschieden ist, enthält und die funktionelle Komponente (D) aus der Gruppe bestehend aus organischen Schleifteilchen, anorganischen Schleifteilchen und organisch-anorganischen Hybrid-Schleifteilchen, die von den Teilchen (A) verschieden sind, mehrwertigen Alkoholen mit mindestens zwei Hydroxygruppen, Substanzen mit einer unteren kritischen Lösungstemperatur LCST oder einer oberen kritischen Lösungstemperatur UCST, Oxidationsmitteln, Passivierungsmitteln, Ladungsumkehrmitteln, Komplex- oder Chelatbildnern, Reibungsmessungen, Stabilisatoren, Rheologiemitteln, Tensiden, Metallkationen und organischen Lösungsmitteln ausgewählt ist.

3. Wässrige Polierzusammensetzung nach einem der Ansprüche 1 bis 2, **dadurch gekennzeichnet, dass** sie mindestens ein pH-Einstellungsmittel oder Puffermittel (E), das von den Komponenten (A), (B) und (C) verschieden ist, enthält.

4. Verfahren zum Polieren von Substratmaterialien für elektrische, mechanische und optische Vorrichtungen durch mindestens einmaliges Kontaktieren des Substratmaterials mit einer wässrigen Polierzusammensetzung und Polieren des Substratmaterials bis zur Erreichung der gewünschten Planarität, **dadurch gekennzeichnet, dass** die wässrige Polierzusammensetzung nach einem der Ansprüche 1 bis 3 verwendet wird.

5. Verfahren nach Anspruch 4, **dadurch gekennzeichnet, dass** das Substratmaterial mindestens eine Schicht, die mindestens ein dielektrisches Siliciumoxidmaterial enthält oder daraus besteht, und mindestens eine Schicht, die Siliciumnitrid enthält oder daraus besteht, umfasst.

6. Verfahren nach einem der Ansprüche 4 bis 5, **dadurch gekennzeichnet, dass** es sich bei den elektrischen Vorrichtungen um Vorrichtungen mit integrierten Schaltungen handelt, die integrierte Schaltungen mit hohem Integrationsgrad oder sehr hohem Integrationsgrad mit Strukturen mit Abmessungen unterhalb von 50 nm enthalten.

7. Verwendung der wässrigen Polierzusammensetzung nach einem der Ansprüche 1 bis 3 zur Herstellung von elektrischen, mechanischen und optischen Vorrichtungen.

8. Verwendung von kationisch modifizierten Flockungsmitteln (c3) mit einem gewichtsmittleren Molekulargewicht von weniger als 100.000 Dalton zur Stabilisierung von Dispersionen, die mindestens einen Typ von Schleifteilchen (A), die bei Dispergierung in einem wässrigen Medium mit einem pH-Wert von 3 bis 9 gemäß der elektrophoretischen Mobilität positiv geladen sind, enthalten.

## Revendications

1. Composition de polissage aqueuse comprenant
(A) au moins un type de particules inorganiques abrasives (A) qui contiennent ou sont constituées d'oxyde de cérium qui sont positivement chargées lorsqu'elles sont dispersées dans un milieu aqueux ayant un pH dans la plage de 3 à 9 comme indiqué par la mobilité électrophorétique ;
(B) au moins un composant contenant un groupe hydroxy hydrosoluble et dispersible dans l'eau choisi dans le groupe constitué de
(b1) acides hydroxycarboxyliques aliphatiques et cycloaliphatiques ayant au moins trois atomes de carbone, au moins deux groupes hydroxy et au moins un groupe acide carboxylique sur la molécule, le rapport molaire des groupes hydroxy aux groupes acide carboxylique étant d'au moins 2 ;
(b2) esters des acides hydroxycarboxyliques (b1) ayant au moins un groupe choisi dans le groupe constitué de groupes lactone, groupes hydroxy estérifiés, groupes acide carboxylique estérifiés et des mélanges de ceux-ci, à condition qu'au moins deux groupes hydroxy soient présents dans (b2) ; et
(b3) des mélanges de ceux-ci ; et
(C) au moins un composant polymère hydrosoluble et dispersible dans l'eau choisi dans le groupe constitué de
(c1) homopolymères et copolymères d'oxyde d'alkylène linéaires et ramifiés choisis dans le groupe constitué d'homopolymères et copolymères d'oxyde d'éthylène et d'oxyde de propylène et des mélanges de ceux-ci ;
(c2) et
(c3) des floculants polymères cationiques ayant un poids moléculaire moyen en poids inférieur à 100 000 daltons choisis dans le groupe constitué de polyacrylamides, polyamines, polyéthylénimines, poly(halogénure de diallyl-N,N-dialylammonium) à modification cationique et des mélanges de ceux-ci,
dans laquelle (B) est choisi dans le groupe constitué de l'acide quinique, la glucono-δ-lactone, l'acide glucuronique, l'acide lactobinonique et un mélange de ceux-ci,
et la composition ayant un pH dans la plage de 2,5 à 4.

2. Composition de polissage aqueuse selon la revendication 1, **caractérisée en ce qu'**elle contient au moins un composant fonctionnel (D) différent des composants (A), (B) et (C), et le composant fonctionnel (D) est choisi dans le groupe constitué de particules abrasives organiques, inorganiques et hybrides organiques-inorganiques étant différentes des particules (A), des alcools polyhydriques ayant au moins deux groupes hydroxy, des matériaux ayant une température de solution critique inférieure LCST ou une température de solution critique supérieure UCST, des agents oxydants, des agents de passivation, des agents d'inversion de charge, des agents complexants ou chélateurs, des agents de frottement, des agents stabilisants, des agents de rhéologie, des tensioactifs, des cations métalliques et des solvants organiques.

3. Composition de polissage aqueuse selon l'une quelconque des revendications 1 à 2, **caractérisée en ce qu'**elle contient au moins un agent d'ajustement de pH ou un agent tampon (E) différent des composants (A), (B) et (C).

4. Procédé de polissage de matériaux de substrat pour des dispositifs électriques, mécaniques et optiques par mise en contact du matériau de substrat au moins une fois avec une composition de polissage aqueuse et polissage du matériau de substrat jusqu'à ce que la planéité souhaitée soit obtenue, **caractérisé en ce que** la composition de polissage aqueuse selon l'une quelconque des revendications 1 à 3 est utilisée.

5. Procédé selon la revendication 4, **caractérisé en ce que** le matériau de substrat comprend au moins une couche contenant ou constituée d'au moins un matériau d'oxyde de silicium diélectrique et au moins une couche contenant ou constituée de nitrure de silicium.

6. Procédé selon l'une quelconque des revendications 4 à 5, **caractérisé en ce que** les dispositifs électriques sont des dispositifs à circuits intégrés qui contiennent des circuits intégrés avec une intégration à grande échelle ou une intégration à très grande échelle ayant des structures avec des dimensions inférieures à 50 nm.

7. Utilisation de la composition de polissage aqueuse selon l'une quelconque des revendications 1 à 3 pour fabriquer des dispositifs électriques, mécaniques et optiques.

8. Utilisation de floculants à modification cationique (c3) ayant un poids moléculaire moyen en poids inférieur à 100 000 daltons pour la stabilisation de dispersions contenant au moins un type de particules abrasives (A) qui sont positivement chargées lorsqu'elles sont dispersées dans un milieu aqueux ayant un pH dans la plage de 3 à 9 comme indiqué par la mobilité électrophorétique.
